# EUROPEAN PATENT APPLICATION

(11) **EP 2 326 008 A1**
(43) Date of publication of application: **25.05.2011**
(21) Application number: 10191400.0
(22) Date of filing: 16.11.2010
(51) Int. Cl.: H03K 19/003

(54) **A simple self-adjusting overvoltage-protection circuit for low voltage CMOS input and output interface circuits with high voltage tolerance and with full rail-to-rail bidirectional voltage levels**

(30) Priority: 20.11.2009 US 623214
(71) Applicant: NXP B.V., 5656 AG Eindhoven (NL)
(72) Inventor: Mann, Allen James, Redhill, Surrey RH1 1DL (GB); Mahooti, Kevin, Redhill, Surrey RH1 1DL (GB)
(74) Representative: Burton, Nick

(57) **Abstract**

A modified CMOS switch (402), composed of parallel N-channel (410) and P-channel (412) transistors, is placed between the pad (14) and the input buffer and/or output devices (404). The applied pad voltage relative to V_{DD} determines the configuration of the switch (402), and also, the P-channel floating-well bias-voltage (nw). For the applied pad voltage above V_{DD}, only the N-channel device (410) is on and the P-channel device (412,414) is off. In this configuration the N-channel limits the input voltage on the buffer side to (V_{DD}-V_{TN}), and therefore, acts as the over-voltage protection device. For pad voltages at and below V_{DD}, both the N-channel (410) and the P-channel devices (414) are on, and the voltage-levels on both sides of the protection structure are the same.

## Description

### TECHNICAL FIELD

The technical field relates generally to Complementary Metal Oxide Semiconductor (CMOS) input/output pad circuits.

### BACKGROUND

CMOS is a very widely used technology for semiconductor components such as, for example, MOS transistors (MOSTs), particularly within fabricated integrated circuits (ICs). CMOS is used to implement digital logic circuits such as microprocessors, microcontrollers, and memories, as well as analog circuits such as, for example, highly integrated transceivers.

Benefits of CMOS devices include high noise immunity and, particularly in binary logic CMOS circuits, low static power consumption and high density of logic functions per unit chip area. CMOS binary logic circuits typically have rail-to-rail logic level voltage swings and low static power consumption because such logic operations, in changing between logical "0" (the ground rail) and logical "1" (the voltage supply rail) states, typically toggle CMOS transistors between one of a switched off state (hereinafter "OFF") and a fully saturated conducting state (hereinafter "ON") and the other of these states. Significant power is drawn only during the interval the CMOS transistors are switching between the ON and OFF states, or more clearly, between logic levels. CMOS devices therefore do not typically produce as much wasted heat-energy as other technologies that may implement binary logic such as, for example, transistor-transistor logic (TTL) or N-channel Metal Oxide Semiconductor (NMOS) logic which use N-channel devices without P-channel devices.

A well-known design issue in using CMOS, particularly in a mixed arrangement with TTL, is that CMOS typically requires lower operating voltages than the more ubiquitous 5V TTL standard that has existed for many years. As an illustrative example, a CMOS operating voltage of approximately 3V has been in use for a considerable number of years. In a mixed operating voltage environment where, for example, both a 5V rail and a 3V rail coexist, a 5V signal may be applied to a pin designed for 3V.

Labeling the CMOS voltage "V_{DD}" for purposes of generality, this application of a relatively high voltage, i.e., greater than V_{DD}, to a low voltage V_{DD} pin may occur by design, such as where CMOS devices having a V_{DD} of, for example, approximately 3V and other devices, having an operating voltage of, for example, 5V, share a common bus. Alternatively, the application of a voltage higher than V_{DD} to the CMOS logic input/output pins may occur during "live insertion", or, by other accident, wherein a high voltage signal is cross-connected to such a low voltage pin.

For the above reason, designers of CMOS devices intended for use in a mixed voltage environment, particularly designers of the external interface circuits, i.e., the input-output (I/O) circuits or pad cells connected between the I/O pads and CMOS internal circuitry, must target the pad cell design to meet two different applied input voltage ranges, namely (i) the lower CMOS operating range, 0 to V_{DD}, and (ii) a higher over-voltage range such as, for example, V_{DD} up to approximately the 5V TTL standard voltage level. Stated differently, for CMOS chip circuitry connected to pad cells, they are designed to be 5V tolerant and can safely have 5V applied to their pad without damaging them.

Many types of over-voltage tolerant CMOS pad cells, all attempting a solution to the CMOS over-voltage protection problem, are known in the related art.

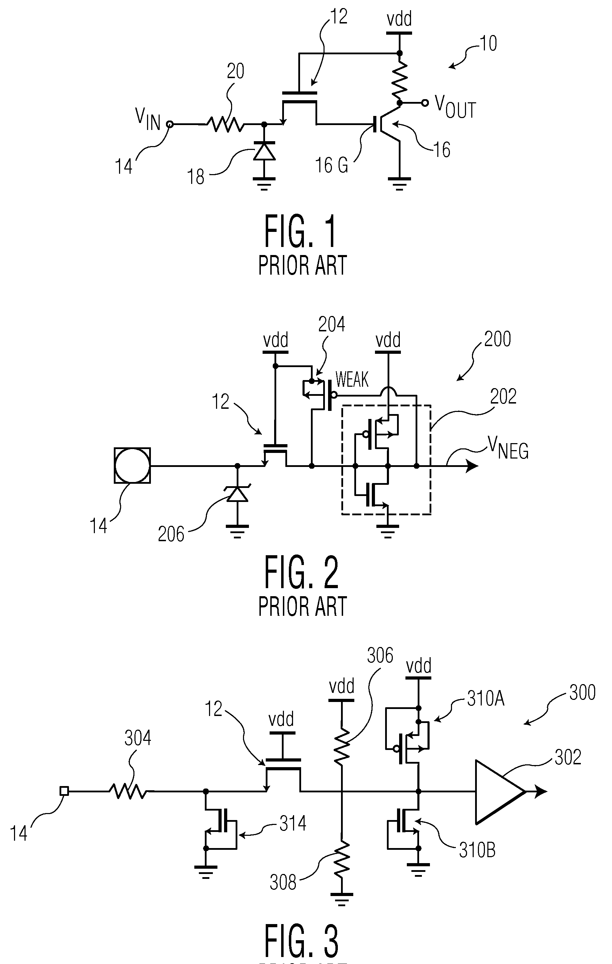

One particularly well-known type is illustrated by the related art FIG. 1 circuit 10. Referring to FIG. 1, the circuit 10 has an N-channel pass transistor (NMOST) 12 in series between the I/O pad 14 and the gate 16G of the input buffer 16, with the gate 12G of the transistor 12 connected to the supply voltage (V_{DD}). The N-channel pass transistor 12 limits the input over-voltage applied at the I/O pad 14 to (V_{DD} - V_{TN}) at gate 16G of the buffer 16, where V_{TN} is the threshold voltage of the transistor. Reverse bias diode 18 may be included for additional over-voltage protection (e.g. Electrostatic Discharge, ESD), and current limiting resistor 20 may also be included. The N-channel over-voltage protection circuit illustrated in the related art FIG. 1 has been known in the art for more than thirty years, but an inherent issue is that the voltage at the buffer input, instead of being V_{DD}, is at the lower value of (V_{DD} - V_{TN}). Full rail-to-rail operation of the CMOS circuitry at the I/O pad circuits is therefore not obtained.

One known compensation for the reduced CMOS input voltage resulting from the FIG. 1 type of over-voltage protection is illustrated as circuit 200 at the related art FIG. 2 and, as shown by its description in, for example, U.S. Patent No. 5,319,259, issued to Merrill, has been known in the art since at least 1994. Referring to the related art FIG. 2, the circuit inserts an inverting buffer 202 between the source (not separately numbered) of the N-channel pass transistor 12 and the input (not shown in FIG. 2) of the next CMOS circuit, and a weak drive strength (also termed a "weak" or "resistive" pull-up) P-channel transistor (PMOST) 204 between V_{DD} and the junction of the N-channel transistor 12 source and the input 202A of the inventing buffer 202

With continuing reference to FIG. 2, when the pad 14 is driven by V_{DD}, the initial voltage at the source (not separately numbered) of the N-channel transistor 12 is (V_{DD} - V_{TN}). This is not high enough, though, to completely switch OFF the top P-channel transistor (not separately numbered) of the inverting buffer 202 and completely switch ON the bottom N-channel transistor (not separately numbered), which drives the Vneg output to ground. This ground signal is fed back to the gate (not separately numbered) of the weak pull-up transistor 204, thereby pulling up to V_{DD} the junction of the N-channel transistor 12 source and the inverting buffer input 202A.

With continuing reference to the related art FIG. 2, a long-known drawback is that the weak pull-up transistor 204 combined with the inverting buffer 202 forms a half-latch, and when the pad 14 is not driven, the voltage observed at the pad 14, due to the internal weak pull-up transistor 204 located at the input buffer is (V_{DD} - V_{TN}). For this reason, when used in a wired-OR type port operation, an external pull-up (not shown in FIG. 2) is required for all voltage environments, even for single supply applications.

The related art FIG. 3 shows, in an abstracted form, an example 300 another known compensation for the reduced CMOS input voltage resulting from the FIG. 1 type of over-voltage protection and, as shown by its description in, for example, TSMC Universal Standard I/O Library General Application Note, version 2.00, April 2008, pp16+ (published by the Taiwan Semiconductor Manufacturing Company Ltd., copyright 2004), this structure has been known in the art since at least 2004. Referring to the related art FIG. 3, the example 300 employs an N-channel pass transistor 12 in the same general arrangement as shown in the related art FIGS. 1 and 2, with a buffer 302, an input resistor 304, a controllable weak pull-up resistor element 306 and a similar controllable weak pull-down resistor element 308. The circuit 300 also utilizes an over-voltage protection diode-configured MOST 310A and similar diode-configured MOST 310B at the buffer 302 input, and another over-voltage protection section formed of another diode-configured MOST 314 between the I/O pad 14 and the N-channel pass transistor 12.

The circuitry implementing the controllable weak pull-up resistor elements 306 and 308, however, is complex. Further, the weak pull-up/pull-down resistor elements 306 and 308 are located at inboard side of the N-channel pass transistor 12 and, therefore, the voltage at the I/O pad 14 is limited to (V_{DD} - V_{TN}). For this reason, in commonly used bidirectional bus or wired-OR type applications, the weak pull-up resistive elements 306 and 308 cannot be used to pull the pins of other devices up to V_{DD}. Therefore, using circuitry such as the related art FIG. 3 in such applications requires an additional external pull-up device.

### SUMMARY

Various examples according to one or more general embodiments provide, among other features and benefits, over-voltage tolerance for CMOS circuitry connected to an I/O pad, as well as provide full rail-to-rail (e.g., 0V to V_{DD} volts) voltage swing at the drive input of that CMOS circuitry.

Various examples according to one or more general embodiments provide, among other features and benefits, over-voltage tolerance for CMOS circuitry connected to an I/O pad and, at the same, as well as full rail-to-rail voltage swing at the drive input of that CMOS circuitry and, further, provide low static currents.

Various examples according to one or more general embodiments provide, among other features and benefits, a combination of over-voltage tolerance for CMOS circuitry connected to an I/O pad, full rail-to-rail voltage swing at the drive input of that CMOS circuitry, and a further self-adjustment protection structure that, among other features and benefits, blocks voltages applied at the I/O pad from reaching the CMOS circuitry connected to the I/O pad when there is no supply voltage or V_{DD} is 0V.

A modified CMOS switch, composed of parallel N-channel and P-channel transistors (NMOST and PMOST), is placed between the pad and the input buffer and/or output devices. The applied voltage at the pad relative to V_{DD} automatically determines the configuration of the switch, as well as, the P-channel floating-well bias-voltage. For the applied pad voltage above V_{DD}, only the N-channel transistor is on and the P-channel transistor is off, and the floating-well is connected to the pad-voltage. In this configuration the N-channel device (NMOST) limits the input voltage on the buffer side to (V_{DD}-V_{TN}), and therefore, acts as the over-voltage protection device. For pad voltages at and below V_{DD}, both the N-channel and the P-channel devices (NMOST and PMOST) are on, and the floating-well is connected to V_{DD}. In this configuration, the voltage-levels on both sides of the CMOS switch are the same, and the pad static leakage current is very low.

The above-summarized illustrative examples of advances and features of the various exemplary embodiments and aspects are not intended to be exhaustive or limiting of the possible advantages that may be realized. Other advantages of the various exemplary embodiments will be apparent from the various embodiments and aspects that are further described with illustrative detail, and persons of ordinary skill in the art will, upon reading this disclosure, readily identify further variations within the scope of the appended claims, as well as additional applications.

### BRIEF DESCRIPTION OF THE DRAWINGS

FIG. 1 illustrates one example related art N-channel pass transistor (NMOST) over-voltage protection circuit;
FIG. 2 illustrates one example related art N-channel pass transistor (NMOST) over-voltage protection circuit having an example related art weak pull-up structure;
FIG. 3 illustrates one example related art N-channel pass transistor over-voltage protection circuit having another example related art pull-up structure;
FIG. 4 shows a circuit diagram representation of one example circuit implementing according to one self-adjusting I/O pad cell with the "over-voltage protection pass" (OPP) CMOS switch circuit of one embodiment;
FIG. 5 shows one circuit diagram representation of one example implementation of one floating-well bias voltage generating circuit for one example of a self-adjusting I/O pad cell over-voltage protection circuit according to one embodiment;
FIG. 6 shows one circuit diagram representation of one example implementation of one pull-down resistor structure for one example of a self-adjusting I/O pad cell over-voltage protection circuit according to one embodiment;
FIG. 7 shows one circuit diagram representation of one example implementation having one embodiment such as illustrated at FIG. 4, combined with one example drive buffer fed by the example OPP CMOS switch of the FIG. 4 example implementation, and having one illustrative example additional over-voltage protection;
FIG. 8 shows one circuit diagram representation of one example implementation having one embodiment such as illustrated at FIG. 7, combined with one example additional over-voltage protection arranged between the I/O pad and the example OPP CMOS switch of the FIG. 4 and FIG. 7 example implementations; and
FIG. 9 shows one circuit diagram representation of one example implementation, having one embodiment such as that illustrated at FIG. 8, combined with one example implementation of an additional pull-up and pull-down structure arranged between the example OPP CMOS switch of the FIG. 4, FIG. 7 and FIG. 8 examples and the buffer input of the FIG. 7 and 8 example.

### DETAILED DESCRIPTION

Various examples according to exemplary embodiments are described in reference to specific example configurations and arrangements, to assist a person of ordinary skill to form an understanding of the concepts sufficient for the person, applying the knowledge and skills such persons possess, to practice according to the claimed invention. The scope of the embodiments and range of implementations, however, are not limited to these specific illustrative examples. Instead, other configurations, arrangements and implementations for practicing one or more of the embodiments as will be obvious to persons of ordinary skill in the relevant arts upon reading this description.

As will be obvious to persons of ordinary skill in the art upon reading this disclosure, figures may not be drawn to scale, e.g., relative sizes and placements of are not necessarily representative of the items' relative quantity of structure or relative importance of functions. Instead the scale may be arbitrary or may be chosen more clearly depict the figure's illustrated example subject matter.

As will also be understood by persons of ordinary skill in the art upon reading this disclosure, various details of subject matter known to persons of ordinary skill omitted, to avoid obscuring novel features and aspects. Such details include, but are not limited to, general semiconductor layout and simulation tools, as well as device design rules, that are well known to such persons. Similarly, at instances at which details are included, it will be understood by persons of ordinary skill in the art, from the context of the instance, that such details may be described only to the extent pertinent to particular features or aspects of an embodiment.

Example embodiments and aspects may be described separately, or as having certain differences. Separate description or description of differences, however, does not necessarily mean the respective embodiments or aspects are mutually exclusive. For example, a particular feature, function, or characteristic described in relation to one embodiment may be included in, or adapted for other embodiments.

According to one example of one general embodiment, a novel CMOS pass switch, termed herein as an "over-voltage protective pass CMOS switch," or "OPP CMOS switch" is interposed between an I/O pad and a CMOS input buffer and/or CMOS output devices connected to the I/O pad. The OPP CMOS switch may be composed of a parallel arrangement of an N-channel pass transistor and a P-channel pass transistor. The parallel arrangement may include the source of the N-channel pass transistor and the source of the P-channel pass transistor connected together and to a common input path to the I/O pad, and the drain of the N-channel pass transistor may be connected together with the drain of the P-channel pass transistor to a common output path. The common output path may, in turn, connect to an input of a CMOS buffer or other CMOS circuitry.

According to one example of one general embodiment the N-channel pass transistor of the OPP CMOS switch has a threshold voltage, arbitrarily labeled V_{TN}, and the gate of the N-channel pass transistor may be connected to a voltage related to V_{DD}, the voltage preferably being V_{DD}. In one example according to one general embodiment, a P-channel pass transistor control circuit switches the P-channel pass transistor of the OPP CMOS switch between an ON and an OFF state in response to the voltage level of the signal received at the I/O pad. Further, in one example according to one embodiment, the P-channel pass transistor of the control circuit is switched OFF, then the P-channel pass transistor of the OPP CMOS switch is switched ON by the very weak-drive pull-down resistor (Rpd) connected between its gate and ground. If the P-channel pass transistor of the control circuit is switched ON, then the voltage on the I/O pad will drive the voltage on the gate of the P-channel pass transistor of the OPP CMOS switch and switch it OFF.

According to one aspect, the P-channel pass transistor may be formed on a floating well. Further to the one aspect, a floating well bias circuit may be included, the bias circuit arranged to place a self-adjusting bias voltage on the floating well, based on the input signal voltage level on the I/O pad in relation to V_{DD}. According to one aspect, the self-adjusting floating well bias circuit may, in response to the input voltage signal level being not greater than approximately V_{DD}, place a bias voltage on the floating well that is equal to approximately V_{DD}. Since the input signal voltage meeting this condition also leaves the P-channel pass transistor in its ON condition, the P-channel pass transistor passes the input signal to its drain at the bias voltage of the transistor body, i.e., V_{DD}, which is the full swing CMOS switching voltage.

As previously described, according to one general embodiment, the OPP CMOS switch includes an N-channel pass transistor arranged in parallel with the P-channel pass transistor. According to one or more aspects, the gate of the N-channel pass transistor may be connected to V_{DD}. An N-channel pass transistor has a threshold voltage of V_{TN} and, therefore, this connection of its gate to V_{DD} prevents any input signal voltage higher than (V_{DD} - V_{TN}) from passing to its drain. On the other hand, in the absence of the above-described P-channel pass transistor, this characteristic of an N-channel pass transistor over-voltage protection circuit would prevent inputs of the CMOS circuitry, e.g., CMOS buffers, connected to the I/O pad from receiving signals that swing the full V_{DD} range.

One or more of the general embodiments, among other benefits and features, eliminate this (V_{DD} - V_{TN}) reduction in voltage range resulting from an N-channel pass transistor standing alone. According to one aspect, the P-channel pass transistor is arranged and fabricated relative to the N-channel pass transistor so that the drain of the P-channel pass transistor, being biased at V_{DD} in response to I/O pad signals that are not at an over-voltage (e.g. proper CMOS logic signals), pulls up the drain of the N-channel pass transistor to V_{DD}. An N-channel pass transistor standing alone, in contrast, attenuates valid CMOS level logic signals to V_{DD} - V_{TN}. Further, according to one or more aspects, in response to over-voltage signal at the I/O pad, the P-channel pass transistor is switched OFF. The parallel N-channel pass transistor is then the only signal path from the I/O pad to the CMOS logic circuits, and the N-channel pass transistor limits the signal entering the CMOS logic circuits to V_{DD} - V_{TN}. As a result, over-voltage protection circuits according to the general embodiments deliver logic signals to CMOS circuitry at the full-swing V_{DD} level.

In overview, provides features and benefits, including (i) full rail-to-rail performance characteristics of CMOS input and output interface circuits over their nominal supply voltage (V_{DD}) range, (ii) over-voltage protection, (iii) blocking applied input voltages from reaching the input/output devices when there is no supply voltage or V_{DD} is 0V, and (iv) low static currents.

Various aspects further provide pad cell electro-static discharge ("ESD") protection, in which primary ESD protection structures may be placed at the pad, and a secondary ESD protection structure may be placed in front of the modified CMOS switch. Additional diode configured MOS devices may be connected between the buffer-input and the power/ground rails for protection from any excess trapped-charge buildup or over-voltage spikes.

It will be understood that, except in instances where otherwise stated or made clear from a particular context to have different meaning, the phrase "I/O interface" means the interface may be an input cell, i.e., a cell only for purposes of receiving signals at the I/O pad, or may be a bi-directional cell.

Referring now to the figures, illustrative examples among the ranges of arrangements, architectures, systems and structures for practicing one or more of the various example embodiments will be described.

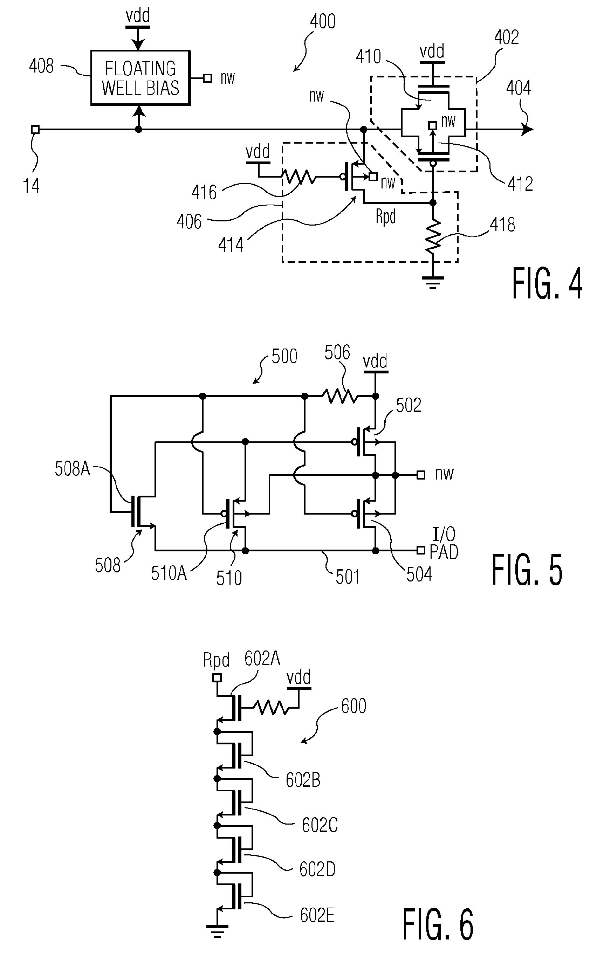

FIG 4 is a circuit diagram representing one example circuit 400 having one example I/O interface cell in according with one embodiment. For purposes of focusing on illustrative examples of novel features, the example 400 is depicted as an input interface cell.

Referring now to FIG. 4, the example 400 includes an I/O pad 14 connected via a conduction path 401 to an input 402A of an over-voltage protective pass CMOS switch 402. The over-voltage protective pass CMOS switch 402 comprises a parallel arrangement of a N-channel pass transistor 410 and a P-channel pass transistor 412, having their respective sources (not separately numbered) connected together and to the input 402A of the over-voltage protective pass (OPP) CMOS switch 402, and their respective drains (not separately numbered) connected together and to an output 402B of this (OPP) CMOS switch 404.

It will be understood that the terms "over-voltage protective pass CMOS switch" and "OPP CMOS switch" are arbitrary labels selected solely for maintaining a clear and consistent reference to the depicted example structures. These reference labels, however, are not intended as being any definition of structure, or has having any meaning with respect to a principle of operation.

It will be understood that, unless otherwise stated or otherwise made clear from the particular context, the terms "input" and "output," as used with respect to the OPP CMOS switch 404, are only reference to an external voltage applied to the pad 14 being an "input." The terms "input" and "output," unless otherwise stated, are not intended as a reference to the direction of logical circuits entering or exiting the pad 14.

With continuing reference to FIG. 4, the output 402B of the OPP CMOS switch 402 may connect to a CMOS logic circuit input (not shown in FIG. 4). In the example circuit 400, a control circuit such as, for example, the depicted P-channel control switch 406, selectively controls or switches the P-channel transistor 412 of the OPP CMOS switch 402 between an ON and an OFF state, depending on the value of the voltage V_{IN} appearing on the pad 14, as will be described in greater detail at later sections.

Referring to FIG. 4, a floating well bias circuit such the example 408 is one example implementation of a self-adjustment aspect according to one or more embodiments. The example floating well bias circuit 408 detects the V_{IN} voltage from the input pad 14 and, based on a comparison of V_{IN} and V_{DD}, generates a floating well bias voltage signal, labeled "NW," having one of two values, namely one of V_{DD} and V_{IN}. In overview, in the example circuit 400, if V_{IN} is not greater than V_{DD} the floating well bias circuit 408 generates NW equal to V_{DD}. This biases at V_{DD} the floating well (not shown in the figures) on which the P-channel pass transistor 412 and the P-channel switch transistor 414 are formed. If V_{IN} is greater than V_{DD} the floating well bias circuit 408 generates NW equal to V_{IN}. This, in turn, biases the body of the P-channel pass transistor 412, and the body of the P-channel switch transistor 414, at V_{IN}. The bias may therefore be described as "self adjusting."

As will be understood to persons of ordinary skill in the art upon viewing this entire disclosure, the self-adjusting bias voltage NW generated by the circuit 408 effects a relationship between both the ON voltage and the OFF voltage, measured relative to the reference potential or GND, and the voltage V_{IN} at the pad 14, of both the P-channel pass transistor 412 and the P-channel switch transistor 414. This relationship of the ON and OFF voltages of P-channel transistors 412 and 414 and the V_{IN} voltage, combined with the novel parallel arrangement of the P-channel pass transistor 412 with the N-channel pass transistor 410, provides over-voltage protection, removes the reduced voltage swing issue inherent to an N-channel pass transistor standing alone.

Various implementations of a circuit performing the function of the circuit 408 will be obvious to persons of ordinary skill based on this disclosure. For convenience, one illustrative example circuit, further depicted as circuit 500 at FIG. 5, to implement the floating well bias 408 is further described at later sections of this disclosure.

With continuing reference to FIG. 4, in the illustrative example 400 circuit the P-channel control switch 406 example of an implementation of the above-described control of the P-channel transistor 412 is formed of a P-channel pass transistor 414 having its gate (not separately numbered) connected via a resistor element 416 to V_{DD}, and its source (not separately numbered) connected to the transmission path 401, i.e., to the input 402A of the OPP CMOS switch 402. The drain (not separately numbered) of the example P-channel pass transistor 414 is connected, preferably via a high, e.g., weak resistor element such as the example 418, to a system reference or ground potential , referenced herein as "GND."

For purposes of this description, "weak" means a substantially lower drive strength, or a substantially higher ON resistance, than that of transistors intended to source or sink a signal current. As one illustrative example ratio, in a circuit having pass transistors intended to pass from approximately two to approximately five milliamps, a "weak" drive strength or "weak" pull-up transistor may have a maximum current carrying capacity of approximately one to ten microamps.

Operation of this illustrative example is as follows: If V_{IN} is greater than V_{DD} the gate-to-source voltage of the P-channel switch transistor 414 switches the transistor ON. Current then flows through the P-channel switch transistor 414, and through the weak resistor 418 to ground. This raises the voltage at the gate of the P-channel pass transistor 412 to substantially the same level as voltage at the source of that transistor, which switches the P-channel pass transistor 412 OFF.

The above-described illustrated example circuitry controlling the P-channel pass transistor 412 is only one example. Various alternative implementations will be apparent to persons of ordinary skill in the art in view of this entire disclosure. One, but not the only such example alternative for a voltage sensing circuit to detect the voltage level on the I/O pad relative to V_{DD} is a second higher supply-voltage (not shown in the drawings) either from an external voltage source or generated on-chip by, for example, a charge-pump, combined with an actual PMOST differential pair input analog comparator (not shown) connected to a latch-type inverter (not shown) output. The latch-type inverter output of this example alternate voltage sensing circuit would be, in turn, connected to the gate of the P-channel pass transistor of the OPP CMOS switch.

Referring to FIG. 4, it will also be readily seen by persons of ordinary skill in the art, upon viewing this disclosure in its entirety, that in the event of a loss of power V_{DD}, the self-adjusting bias voltage NW generated by the circuit 408, combined with the parallel arrangement of the N-channel pass transistor 410 and P-channel pass transistor 412 of the OPP CMOS switch 402, prevents any signal at the I/O from passing through. Stated more particularly, in reference to the FIG. 4 example 400, if V_{DD} is OFF or in a failure state, the N-channel pass transistor 410 of the OPP CMOS switch 402 is clearly OFF. Turning now to the P-channel pass transistor 412, since its bias voltage NW controls its transfer characteristic, describing the characteristic of the transistor 412 in the event of a V_{DD} failure requires first identifying the NW voltage that will be generated by the circuit element 408 if there is a V_{DD} failure. An example implementation of the floating well bias circuit 408 is described below in reference to FIG. 5. As will be described, the FIG. 5 example implementation sets the bias voltage NW as the V_{IN} voltage at the I/O pad 14 if there is a V_{DD} failure.

Referring now to FIG. 4, the transfer characteristic of the P-channel pass transistor 412 in the event of a V_{DD} failure can now be identified. More particularly, it is seen that the V_{IN} will be applied to the source of the control switch transistor 414, because the I/O pad 14 is electrically connected to that source. The gate of the control switch transistor 414 is at zero. Therefore, at all instants that V_{IN} is positive the gate-to-source voltage of the transistor 414 must be negative. The control switch transistor 414 is always ON for a positive V_{IN} during a V_{DD} failure. This provides a current path from the I/O pad 14 to the weak pull-down resistor element 418. A positive V_{IN} will therefore push a current through the weak pull-down resistor element 418 which, in turn, forces a positive voltage at the gate of the P-channel pass transistor 412, having a level substantially the same as V_{IN}. The source and the gate of the P-channel pass transistor 412 are therefore connected together in response to a positive V_{IN} occurring at the I/O pad during a V_{DD} failure.

Therefore, as seen from the FIG. 4 example 400, in an over-voltage protection circuit having an over-voltage protection according to the OPP CMOS switch of the disclosed embodiments, both the P-channel pass transistor and the N-channel pass transistor 410 are cut OFF to a positive V_{IN} during a V_{DD} failure.

FIG. 5 is one circuit diagram representation of one example implementation of one floating-well bias voltage generating circuit for one example self-adjusting I/O pad cell over-voltage protection circuit according to one embodiment. The FIG. 5 circuit may implement, but is not the only implementation for, the floating well bias circuit 408 illustrated in the FIG. 4 example circuit 400.

Referring now to FIG. 5, the illustrative example 500 includes a stack of two P-channel MOSTs 502 and 504 extending in a series connection between the CMOS V_{DD} rail and a rail or other conducting path 501 to the I/O pad 14. The P-channel MOSTs 502 and 504 are depicted at FIG. 5, by the arrows connecting their respective bodies to the "NW" point, as being formed on the same floating well. The example floating well bias circuit 500 further includes a connection of the CMOS V_{DD} rail by way of, for example, a V_{DD} resistive element 506, to the gates 508A and 510A, respectively, of a parallel arrangement of an N-channel MOST 508 and a P-channel MOST 510. The V_{DD} resistive element 506 is an optional structure, and may be included for purposes such as, for example, suppressing voltage glitches, and also, ESD over-voltage protection of the thin gates oxide. The drain (not separately numbered) of the N-channel MOST 508 and the source (not separately numbered) of the P-channel MOST 510 are connected together and to the gate (not separately numbered) of the top P-channel MOST 502 in the above-described two MOST stack of 502 and 504. The function of the parallel N and P-channel transistors is to turn ON and OFF the P-channel MOST 502, thereby connecting and disconnecting the midpoint node NW to V_{DD}. The gate (not separately numbered) of the bottom P-channel MOST 504 and the gates 508A and 510A of the parallel MOSTs 508 and 510 are all connected together and (through the optional resistive element 506 in the depicted example) to the V_{DD} rail. The gates 508A, 510A and the gate of the bottom P-channel MOST 504 are thus maintained at V_{DD}.

Referring to FIG. 5, as can be seen by persons of ordinary skill in the art from FIG. 5, because of the above-described and depicted connection of V_{DD} to the gates of the MOSTs 508 and 510 and to the gate of the lower P-channel MOST 504, when the V_{IN} voltage at the I/O pad 14 sufficiently exceeds the CMOS rail voltage V_{DD} (by an amount, readily ascertainable to a person of ordinary skill in the art as corresponding to the threshold voltages of the MOSTs 504, 508 and 510) lower P-channel MOST 504 is switched ON and the upper P-channel MOST switched OFF, thereby connecting the midpoint connection feeding NW voltage to the I/O pad 14. In a corresponding manner, when the V_{IN} voltage on the I/O pad 14 is less than or equal to the CMOS rail voltage V_{DD}, the lower P-channel MOST 504 is switched OFF and the upper P-channel MOST switched ON, thereby connecting the midpoint connection feeding NW voltage to the CMOS rail voltage VDD.

Stated more specifically, in operation when the voltage at the I/O pad 14, which is connected to the source of the lower P-channel MOST 504, rises sufficiently above V_{DD} (i.e., above the threshold of the MOST 504), the P-channel MOST 504 switches ON, connecting the NW point to the I/O pad 14. The I/O pad 14 is also connected to the source of the N-channel MOST 508, and to the drain of the P-channel MOST 510. Since at this point the V_{IN} voltage at the I/O pad 14 is above V_{DD}, the gate-to-source voltage of the N-channel MOST 508 is negative, which switches MOST 508 OFF. The gate-to-drain voltage of the P-channel MOST 510 is also negative and, being a P-channel device, this switches the MOST 510 ON, which connects the V_{IN} at the I/O pad 14 to the gate of the upper P-channel MOST 502. This switches the upper P-channel MOST 502 OFF.

With continuing reference to FIG. 5, when the voltage at the I/O pad 14, falls to and below V_{DD} the P-channel MOST 504 switches OFF and the P-channel MOST 510 switches OFF. At the same time, the gate-to-source voltage of the N-channel MOST 508 is sufficient to switch the MOST 508 ON. Because of the drain-to-source voltage drop across the MOST 508, and because the source of the top P-channel MOST 502 is connected directly to V_{DD}, the gate-to-source voltage at the MOST 502 is negative. This switches the top P-channel MOST 502 ON, connecting the NW feed point to V_{DD}.

FIG. 6 is one circuit diagram representation of one example circuit 600 implementation of one pull down resistor element for one example control of a P-channel pass transistor element of one OPP CMOS switch of an over-voltage protection circuit according to one embodiment. Referring to the above-described example depicted at FIG. 4, the FIG. 6 example 600 may implement the pull-down resistor element 418 of the control 406 shown controlling the P-channel pass transistor 412 of the FIG. 4 example OPP CMOS switch 402.

Referring to FIG. 6, the example 600 comprises a stack of diode configured N-channel transistors, referenced collectively as 602 and individually as 602i. It will be understood that the term "stack" references a functional interconnection of elements, and is not a limitation or constraint on the actual physical arrangement of the elements.

Referring to FIG. 6, the depicted example 600 employs a plurality of five N-channel MOSTs 602; the number five being only an arbitrary example. As shown, in the depicted example 600 the gate (not separately numbered) of an upper transistor 602A connects to V_{DD}, and the drain (not separately numbered) of that upper transistor 602A connects to a pad labeled Rpd which, in reference to the FIG. 4 example 400, corresponds to the Rpd connection to the gate of the P-channel pass transistor 412. With continuing reference to FIG. 6, the lower four transistors, labeled 602_{B} through 602 _{E}, are diode connected, thereby forming an active resistor element such as the example 600.

Referring again to FIG. 6, a physical circuit implementing the diagramed example circuit 600 is readily fabricated as small and compact structure, able to achieve high impedance with minimal die area. As known to persons of ordinary skill in the art, the size of the resistance determines the size of the static input leakage current particularly at applied input voltages at the pad above V_{DD}.

As previously described, the very weak drive pull-down resistor 418 of the FIG. 4 illustrative example is for pulling the gate of the P-channel pass transistor 412 to ground and switching it ON if the P-channel pass transistor 414 is switched OFF. As will be readily understood by persons of ordinary skill in the art, the specific resistance value of the pull-down resistor element 418 is application-specific, but the resistance value would normally be very high to minimize input current consumption and allow the applied I/O pad voltage source to easily over-drive the weak-drive of the pull-down when the P-channel pass transistor 414 is switched ON. The actual value of the resistance 418 is readily identified by such persons through applying ordinary circuit design know-how to the present disclosure.

It will also be understood that the FIG. 6 example 600 is only an illustrative example of one implementation. Other implementations of the pull-down resistor element 418 can be readily identified by persons of ordinary skill in the art based on this disclosure. Illustrative examples of other implementations include, but are not limited to, any known resistor structure such as an N-well resistor, a diffusion resistor, a poly resistor or the like.

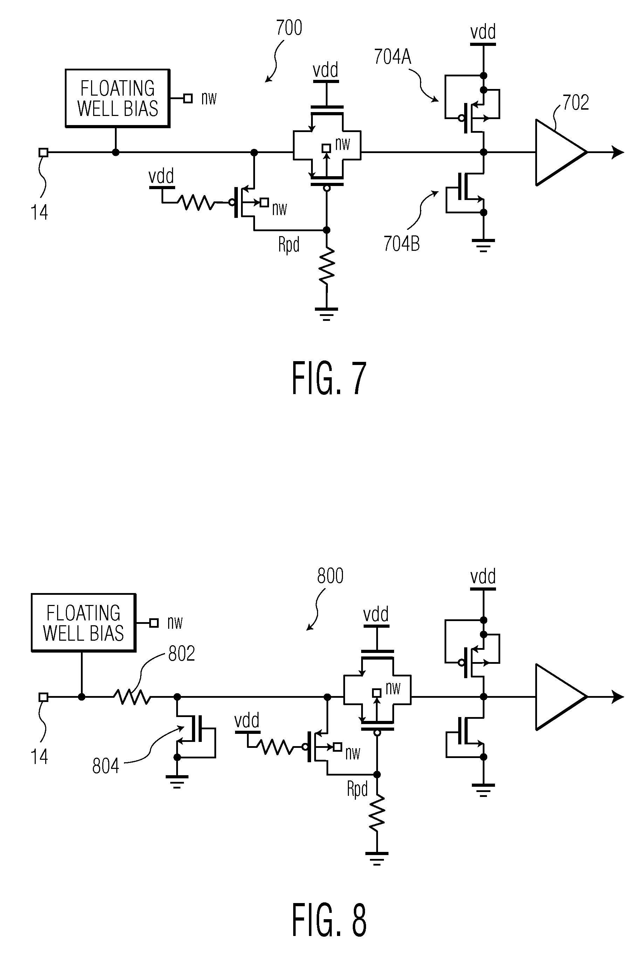

FIG. 7 shows one circuit diagram representation of one example implementation 700 having one embodiment such as illustrated at FIG. 4, combined with one example drive buffer 702 and having an additional over-voltage protection provided by a complementary pair of diode-configured MOSTs, namely a P-channel diode configured MOST 704A connecting the input (not separately numbered) of the buffer 702 to the V_{DD} rail and an N-channel diode configured MOST 704B connecting the buffer 702 input to a GND or equivalent reference voltage. The input buffer 702, as well as the diode-configured MOSTs may be conventional, and have no design or selection criteria that are not specific to the present embodiments.

FIG. 8 shows one circuit diagram representation of one example implementation 800 having one embodiment such as illustrated at FIG. 7, combined with one example additional over-voltage protection, formed by a resistor element 802 and a diode-configured N-channel MOST 804, arranged between the I/O pad 14 and the example OPP CMOS over-voltage pass switch of the FIG. 4 and FIG. 7 example implementations.

The resistor element 802 and the diode-configured MOST 804 may be conventional, and have no design or selection criteria that are not specific to the present embodiments.

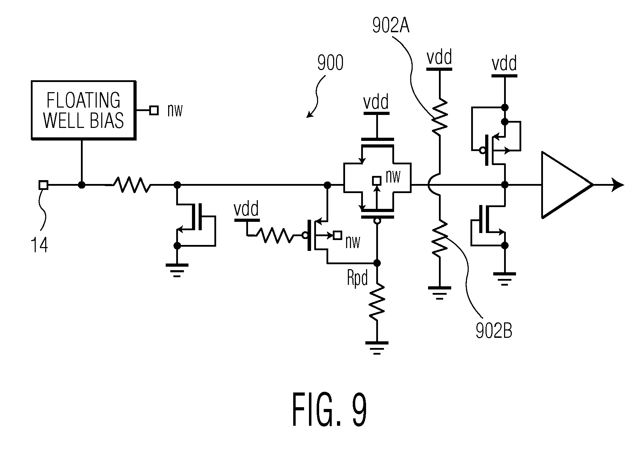

FIG. 9 shows one circuit diagram representation of one example implementation 900, having one embodiment such as that illustrated at FIG. 7, combined with one example implementation of an additional pull-up and pull-down structure 902A and 9902B arranged between the example OPP CMOS switch of the FIG. 4, FIG. 7 and FIG. 8 examples and the input buffer of the FIG. 7 and 8 example.

Referring to FIG. 9, the pull-up and the pull-down structures 902A and 902B can be, for example, a transistor (not specifically shown) or a resistor in series with a pass transistor switch (not specifically shown). The pull-up and the pull-down structures 902A and 902B may be conventional, and have no design or selection criteria that are not specific to the present embodiments.

Further exemplary embodiments are described in the following clauses:
1. A voltage-limiting protection circuit for a CMOS input/output circuit, comprising:an N-channel pass transistor having a source connected to a given external connection pad, a gate connected to a given V_{DD} voltage, and a drain, wherein said N-channel pass transistor has a gate-to-source threshold voltage V_{TN}, and wherein said N-channel pass transistor is structured to generate, in response to a voltage on said source, a voltage on said drain not exceeding (V_{DD} - V_{TN}); a P-channel pass transistor, having a source connected to the source of the N-channel pass transistor, a drain connected to the drain of the N-channel pass transistor, and a gate; and a control switch connected to the gate of the P-channel pass transistor to apply an OFF voltage to switch the P-channel transistor OFF in response to a voltage level at the given external connection pad meeting a first criterion relative to the given V_{DD} voltage value and to apply an ON voltage to switch the P-channel transistor ON in response to said voltage level meeting a second criterion relative to the given V_{DD} voltage value.
2. The voltage limiting circuit of clause 1, wherein the control switch comprises a resistive pull-down element connecting the gate of the P-channel pass transistor to a reference potential, and an ON-OFF switch device connected between the source and the gate of the P-channel pass transistor, and wherein the switch device of the control switch, in response to the voltage level at the given external connection pad meeting the first criterion relative to the given V_{DD} voltage value, forms an open connection between the source and the gate of the P-channel pass transistor, and in response to said voltage level meeting the second criterion relative to the given V_{DD} voltage value, forms a closed connection between the source and the drain of the P-channel pass transistor, and
   wherein, said switch device of the control switch and said resistive pull-down element are structured to establish, in response to said switch device forming said closed connection, a conductive path from the source of the P-channel pass transistor, through the resistive pull-down element, to the given reference potential and to establish, in response to a current flowing through said resistive pull-down element voltage at the gate of the P-channel pass transistor substantially equal to an OFF voltage at the source of the P-channel pass transistor to cut off said P-channel pass transistor.
3. The voltage limiting circuit of clause 2, wherein said ON voltage at the gate of the P-channel pass transistor is said reference voltage, and resistive pull-down element is structured to establish, in response to said switch device of said control switch forming said open connection, a pull-down at the gate of the P-channel pass transistor, pulling said gate to said given reference potential.
4. The voltage limiting circuit of clause 1,
   wherein said P-channel pass transistor is formed on a floating well, and
   wherein said circuit further comprises a floating well bias voltage generator connected to said floating well and connected to said I/O pad, to establish a bias voltage in said floating well based on said given V_{DD} voltage and on the voltage level at said I/O pad.
5. The voltage limiting circuit of clause 4,
   wherein said floating well bias voltage generator, in response to the voltage level at said I/O pad meeting said second criterion relative to the given V_{DD} voltage, establishes the bias voltage in said floating well to be the given V_{DD} voltage, and
   wherein said floating well bias voltage generator, in response to the voltage level at said I/O pad meeting said first criterion relative to the given V_{DD} voltage, establishes the bias voltage in said floating well to be the I/O pad voltage.
6. The voltage limiting circuit of clause 5,
   wherein said first criterion is the voltage level at the I/O pad being no greater than approximately said given V_{DD} voltage, and
   wherein said second criterion is the voltage level at the I/O pad being greater than approximately said given V_{DD} voltage.
7. The voltage limiting circuit of clause 2,
   wherein the control switch includes a P-channel transistor having a source connected to the given external I/O pad, a drain connected to the gate of the P-channel pass transistor, and a gate connected to said given V_{DD} voltage.
8. The voltage limiting circuit of clause 7,
   wherein said P-channel pass transistor is formed on a floating well,
   wherein said control switch P-channel transistor is formed on said floating well, and
   wherein said circuit further comprises a floating well bias voltage generator connected to said floating well and connected to said I/O pad, to establish a bias voltage in said floating well based on said given V_{DD} voltage.
9. The voltage limiting circuit of clause 8,
   wherein said floating well bias voltage generator, in response to the voltage level at said I/O pad meeting said second criterion relative to the given V_{DD} voltage, establishes the bias voltage in said floating well to be the given V_{DD} voltage, and
   wherein said floating well bias voltage generator, in response to the voltage level at said I/O pad meeting said first criterion relative to the given V_{DD} voltage, establishes the bias voltage in said floating well to be the I/O pad voltage.
10. The voltage limiting circuit of clause 9,
   wherein said first criterion is the voltage level at the I/O pad being no greater than approximately said given V_{DD} voltage, and
   wherein said second criterion is the voltage level at the I/O pad being greater than approximately said given V_{DD} voltage.
11. The voltage limiting circuit of clause 2, further comprising:
   an output path connected to the source of the N-channel pass transistor and to the source of the P-channel pass transistor;
   a controllable pull-up element connecting the output path to said given V_{DD} voltage.
12. The voltage limiting circuit of clause 11, further comprising a controllable pull-down element connecting the output path to said given reference potential.
13. The voltage limiting circuit of clause 2, further comprising:
   an output path connected to the source of the N-channel pass transistor and to the source of the P-channel pass transistor;
   a first over-voltage protective element connecting the output path to said given V_{DD} voltage; and
   a second over-voltage protective element connecting the output path to said given reference potential.
14. The voltage limiting circuit of clause 2, wherein said resistive pull-down element includes a very weak drive strength transistor.
15. The voltage limiting circuit of clause 14, wherein said reference voltage is a ground.
16. A voltage-limiting protection method comprising:
   arranging a P-channel pass transistor, having a body, a source, a drain and a gate, between an input/output (I/O) pad and a given I/O path, said arranging including connecting said source to said I/O pad and connecting said drain to said I/O path;
   arranging an N-channel pass transistor, having a source, a drain and a gate, between said I/O pad and said given I/O path, said arranging including connecting said source to said I/O pad and connecting said drain to said I/O path;
   receiving a signal at said I/O pad;
   in response to the signal having a signal voltage level not greater than approximately a given V_{DD} voltage, controlling the P-channel pass transistor to pass the signal to the given I/O path at a passed signal voltage of approximately said given V_{DD} voltage;
   in response to the signal having a signal voltage level greater than approximately a given V_{DD} voltage, cutting OFF the P-channel pass transistor; outputting a corresponding signal at the drain of the N-channel pass transistor and to the output path at a reduced voltage of approximately (V_{DD} - V_{TN}) volts, where V_{TN} is a given threshold voltage of the N-channel pass transistor.
17. The voltage-limiting protection method of clause 16, wherein said controlling the P-channel pass transistor to pass the signal to the given I/O path at a signal voltage level of approximately given V_{DD} voltage comprises:
   biasing the body of the P-channel pass transistor to approximately said given V_{DD} voltage; and
   placing a gate voltage on the gate of the P-channel pass transistor causing said transistor to switch to an ON condition.
18. The voltage-limiting protection method of clause 16, wherein said cutting OFF the P-channel pass transistor comprises:
   biasing the body of the P-channel pass transistor to approximately said signal voltage level; and
   driving the gate of the P-channel pass transistor to a cut-off voltage.
19. The voltage-limiting protection method of clause 17, wherein said cutting OFF the P-channel pass transistor comprises:
   biasing the body of the P-channel pass transistor to approximately said signal voltage level; and
   driving the gate of the P-channel pass transistor to a cut-off voltage.
20. The voltage-limiting protection method of clause 16, further comprising arranging a switching device, having an open and a closed position, between the source and the gate of the P-channel pass transistor, and connecting a weak pull-down resistor element from the gate of the P-channel pass transistor to the given reference voltage,
   wherein said driving the gate of the P-channel pass transistor to a cut-off voltage comprises controlling the switching device to the closed position to form a connection between the source and gate of the P-channel pass transistor, to form a conducting path from said source, through said control switch and through said weak pull-down resistor, wherein a current flowing through said weak pull-down resistive element imposes a voltage drop across said weak pull down resistor element corresponding to said cut-off voltage.
21. The voltage-limiting protection method of clause 18, further comprising arranging an ON-OFF switch device between the source and the gate of the P-channel pass transistor, having an open position and a closed position, and connecting a weak pull-down resistor element from the gate of the P-channel pass transistor to the given reference voltage,
   wherein said driving the gate of the P-channel pass transistor to a cut-off voltage comprises controlling the switching device to the closed portion to form a connection between the source and gate of the P-channel pass transistor, therefore forming a conducting path from said source, through said switching device and through said weak pull down resistor, wherein a current flowing through said weak pull down resistor imposes a voltage drop across said weak pull down resistor element corresponding to a voltage on said source of the P-channel pass transistor, and wherein said voltage is approximately said cut-off voltage,
   wherein said switching device includes a P-channel transistor having a body, and
   wherein said controlling the control switch includes biasing the body of the P-channel transistor to approximately said signal voltage level.

Herein is described a modified CMOS switch, composed of parallel N-channel and P-channel transistors, is placed between the pad and the input buffer and/or output devices. The applied pad voltage relative to V_{DD} determines the configuration of the switch, and also, the P-channel floating-well bias-voltage. For the applied pad voltage above V_{DD}, only the N-channel device is on and the P-channel device is off. In this configuration the N-channel limits the input voltage on the buffer side to (V_{DD}-V_{TN}), and therefore, acts as the over-voltage protection device. For pad voltages at and below V_{DD}, both the N-channel and the P-channel devices are on, and the voltage-levels on both sides of the protection structure are the same.

Although the various exemplary embodiments have been described in detail with particular reference to certain exemplary aspects thereof, it should be understood that the invention is capable of other embodiments and its details are capable of modifications in various obvious respects. As is readily apparent to those skilled in the art, variations and modifications can be affected while remaining within the spirit and scope of the invention.

Accordingly, the foregoing disclosure, description, and figures are for illustrative purposes only and do not in any way limit the invention, which is defined only by the claims.

## Claims

1. A voltage-limiting protection circuit for a CMOS input/output circuit, comprising:
an N-channel pass transistor having a source connected to a given external connection pad, a gate connected to a given V_{DD} voltage, and a drain, wherein said N-channel pass transistor has a gate-to-source threshold voltage V_{TN}, and wherein said N-channel pass transistor is structured to generate, in response to a voltage on said source, a voltage on said drain not exceeding (V_{DD} - V_{TN});
a P-channel pass transistor, having a source connected to the source of the N-channel pass transistor, a drain connected to the drain of the N-channel pass transistor, and a gate; and
a control switch connected to the gate of the P-channel pass transistor to apply an OFF voltage to switch the P-channel transistor OFF in response to a voltage level at the given external connection pad meeting a first criterion relative to the given V_{DD} voltage value and to apply an ON voltage to switch the P-channel transistor ON in response to said voltage level meeting a second criterion relative to the given V_{DD} voltage value.

2. The voltage limiting circuit of claim 1, wherein the control switch comprises a resistive pull-down element connecting the gate of the P-channel pass transistor to a reference potential, and an ON-OFF switch device connected between the source and the gate of the P-channel pass transistor, and
wherein the switch device of the control switch, in response to the voltage level at the given external connection pad meeting the first criterion relative to the given V_{DD} voltage value, forms an open connection between the source and the gate of the P-channel pass transistor, and in response to said voltage level meeting the second criterion relative to the given V_{DD} voltage value, forms a closed connection between the source and the drain of the P-channel pass transistor, and
wherein, said switch device of the control switch and said resistive pull-down element are structured to establish, in response to said switch device forming said closed connection, a conductive path from the source of the P-channel pass transistor, through the resistive pull-down element, to the given reference potential and to establish, in response to a current flowing through said resistive pull-down element voltage at the gate of the P-channel pass transistor substantially equal to an OFF voltage at the source of the P-channel pass transistor to cut off said P-channel pass transistor.

3. The voltage limiting circuit of claim 2, wherein said ON voltage at the gate of the P-channel pass transistor is said reference voltage, and resistive pull-down element is structured to establish, in response to said switch device of said control switch forming said open connection, a pull-down at the gate of the P-channel pass transistor, pulling said gate to said given reference potential.

4. The voltage limiting circuit of claim 1,
wherein said P-channel pass transistor is formed on a floating well, and
wherein said circuit further comprises a floating well bias voltage generator connected to said floating well and connected to said I/O pad, to establish a bias voltage in said floating well based on said given V_{DD} voltage and on the voltage level at said I/O pad.

5. The voltage limiting circuit of claim 4,
wherein said floating well bias voltage generator, in response to the voltage level at said I/O pad meeting said second criterion relative to the given V_{DD} voltage, establishes the bias voltage in said floating well to be the given V_{DD} voltage, and
wherein said floating well bias voltage generator, in response to the voltage level at said I/O pad meeting said first criterion relative to the given V_{DD} voltage, establishes the bias voltage in said floating well to be the I/O pad voltage.

6. The voltage limiting circuit of claim 5,
wherein said first criterion is the voltage level at the I/O pad being no greater than said given V_{DD} voltage, and
wherein said second criterion is the voltage level at the I/O pad being greater than said given V_{DD} voltage.

7. The voltage limiting circuit of claim 2,
wherein the control switch includes a P-channel transistor having a source connected to the given external I/O pad, a drain connected to the gate of the P-channel pass transistor, and a gate connected to said given V_{DD} voltage.

8. The voltage limiting circuit of claim 7,
wherein said P-channel pass transistor is formed on a floating well,
wherein said control switch P-channel transistor is formed on said floating well, and
wherein said circuit further comprises a floating well bias voltage generator connected to said floating well and connected to said I/O pad, to establish a bias voltage in said floating well based on said given V_{DD} voltage.

9. The voltage limiting circuit of claim 8,
wherein said floating well bias voltage generator, in response to the voltage level at said I/O pad meeting said second criterion relative to the given V_{DD} voltage, establishes the bias voltage in said floating well to be the given V_{DD} voltage, and
wherein said floating well bias voltage generator, in response to the voltage level at said I/O pad meeting said first criterion relative to the given V_{DD} voltage, establishes the bias voltage in said floating well to be the I/O pad voltage.

10. The voltage limiting circuit of claim 9,
wherein said first criterion is the voltage level at the I/O pad being no greater than said given V_{DD} voltage, and
wherein said second criterion is the voltage level at the I/O pad being greater than said given V_{DD} voltage.

11. The voltage limiting circuit of claim 2, further comprising:
an output path connected to the source of the N-channel pass transistor and to the source of the P-channel pass transistor;
a controllable pull-up element connecting the output path to said given V_{DD} voltage.

12. The voltage limiting circuit of claim 11, further comprising a controllable pull-down element connecting the output path to said given reference potential.

13. The voltage limiting circuit of claim 2, further comprising:
an output path connected to the source of the N-channel pass transistor and to the source of the P-channel pass transistor;
a first over-voltage protective element connecting the output path to said given V_{DD} voltage; and
a second over-voltage protective element connecting the output path to said given reference potential.

14. The voltage limiting circuit of claim 2, wherein said resistive pull-down element includes a very weak drive strength transistor.

15. The voltage limiting circuit of claim 14, wherein said reference voltage is a ground.
